# FASCICULE DE BREVET EUROPEEN

(11) **EP 1 735 843 B1**
(45) Date de publication et mention de la délivrance du brevet: **23.11.2011**
(21) Numéro de dépôt: 05739553.5
(22) Date de dépôt: 18.03.2005
(51) Int. Cl.: H01L 31/0236, H01L 31/18, C30B 15/24

(54) **PROCEDE DE FABRICATION DE PLAQUES DE SILICIUM POLYCRISTALLIN**
VERFAHREN ZUR HERSTELLUNG VON POLYSILIZIUMFILMEN
METHOD FOR MAKING POLYSILICON FILMS

(30) Priorité: 05.04.2004 FR 0450680
(43) Date de publication de la demande: 27.12.2006
(73) Titulaire: Solarforce, 69760 Limonest (FR)
(72) Inventeur: REMY, Claude, F-69760 Limonest (FR); BELOUET, Christian, F-92330 Sceaux (FR)
(74) Mandataire: Lenne, Laurence
(86) Numéro de dépôt international: PCT/FR2005/050175
(87) Numéro de publication internationale: WO 2005/101527

(56) Documents cités:
- EP-A- 0 079 567
- EP-A- 0 860 885
- FR-A- 2 386 359
- US-A- 5 306 646

## Description

La présente invention concerne un procédé de fabrication de plaques de silicium polycristallin, notamment de faible épaisseur, dont l'une au moins des deux faces de chaque plaque a un relief prédéterminé. Ce relief peut être présent sur la majeure partie de la face (c'est le cas de la texturation par exemple) et/ou sur une faible partie (c'est par exemple le cas du marquage d'une plaque ou du renforcement de sa rigidité par des nervures). Le procédé s'applique tout particulièrement à la fabrication de cellules solaires, appelées cellules photovoltaïques ou photopiles.

Une cellule photovoltaïque type est une diode à jonction *n*-*p*, dont la jonction très peu profonde est parallèle à la surface. Sous éclairement, les photons dont l'énergie *hv* est supérieure à la largeur de bande interdite *E_{g}* du semi-conducteur sont absorbés et créent des paires électron-trou. Les porteurs minoritaires ainsi générés (trous dans la zone n et électrons dans la zone *p*) sont collectés par la jonction *n*-*p*. Il en résulte un courant *lₚₕ*, qui circule de la région *n* vers la zone *p*. Des contacts métalliques sont réalisés sur la surface de la zone de type *n* (émetteur) et sur la face arrière de la zone de type *p* (base) pour collecter ce courant.

Le marché de l'électricité photovoltaïque est dominé par les cellules photovoltaïques du type jonction *n*-*p* (ou *p-n)* réalisées sur du silicium cristallisé. Il est toujours nécessaire de rechercher la valeur maximale de la densité de photocourant générée sous un éclairement donné. Ceci revient à maximiser la collecte des porteurs minoritaires générés par la partie utile du rayonnement incident (photons d'énergie *hv* > *E_{g}*). Plusieurs méthodes sont utilisées à cet effet. On peut citer par exemple l'augmentation d'épaisseur de la base pour permettre l'absorption des photons de grande longueur d'onde-proche infrarouge (mais au détriment de la consommation de silicium), la réduction de la profondeur de la jonction pour favoriser l'absorption des photons de courte longueur d'onde - proche UV - dans la base, le dépôt d'une couche anti-reflet sur la face éclairée pour améliorer la collecte du rayonnement incident ou encore la réduction des processus de recombinaison aux interfaces (face avant, face arrière, contacts).

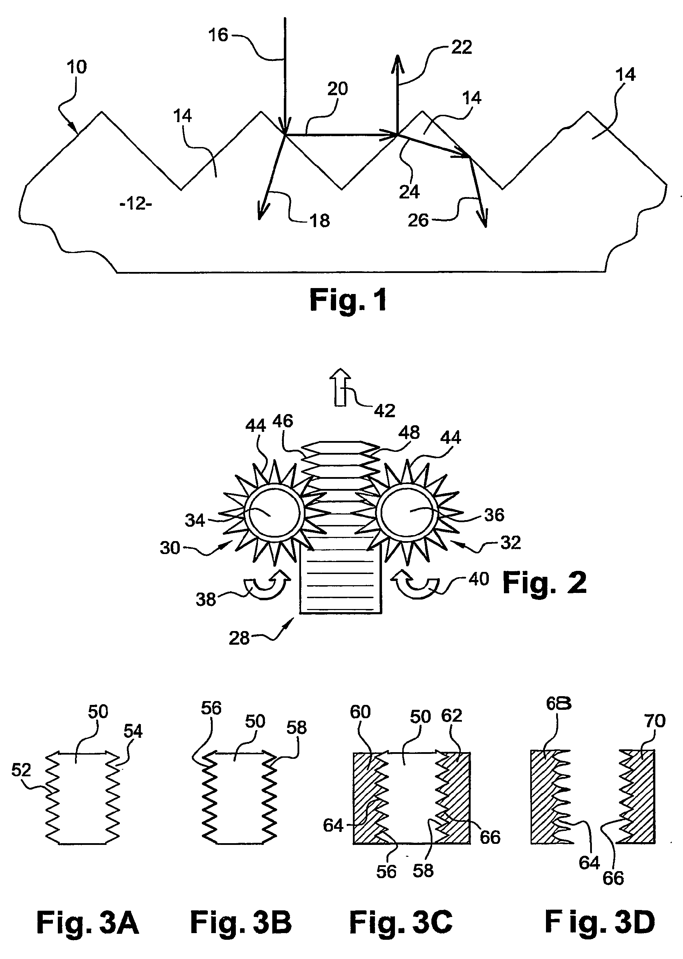

Une dernière méthode est la texturation de la surface. Cette méthode, décrite par exemple dans l'article de J.Nijs, J.Szlufcik, J.Poortmans et al., publié dans IEEE Trans. Electron Devices 46 (10) (1999) 1948, consiste à former en surface un relief, autrement dit à texturer la surface, en forme de pyramides. La figure 1 illustre le principe de fonctionnement de cette méthode. La face 10 de la couche de silicium 12 qui reçoit la lumière est composée d'un réseau de pyramides quasi identiques et adjacentes 14 (des triangles en coupe) dont les faces latérales forment un angle d'environ 45 degrés par rapport à la base des pyramides. Un faisceau lumineux incident 16 normal à la surface donne lieu d'une part à un faisceau réfracté 18, qui est absorbé dans la couche 12, et à un faisceau réfléchi 20. Ce dernier arrive sur la pyramide voisine et donne lieu d'une part à un faisceau réfléchi 22 qui s'éloigne de la couche de silicium et est donc perdu et d'autre part à un premier faisceau réfracté 24, puis à un second faisceau réfracté 26 qui est absorbé par la couche. Ce relief augmente ainsi le rendement global de la cellule photovoltaïque. En effet :
- le coefficient effectif de réflexion de la lumière sur la face d'entrée est réduit, notamment dans le cas d'une lumière incidente à forte composante en lumière diffuse, et
- l'angle d'inclinaison des rayons lumineux qui se propagent dans la base par rapport à la surface macroscopique de la cellule photovoltaïque est fortement augmenté, avec deux conséquences : d'une part, un accroissement de la distance de propagation dans la base du semi-conducteur et, d'autre part, une augmentation du coefficient de réflexion de la lumière sur la face arrière du semi-conducteur. Ces deux effets augmentent la probabilité d'absorption des photons de grande longueur d'onde. Par voie de conséquence, ils contribuent à augmenter la densité de photocourant et la tension de circuit ouvert de la photopile par rapport à une photopile dont la couche de silicium serait munie de faces planes.

La présence d'une telle texturation devient très importante pour le maintien de hauts rendements de conversion lorsque l'on veut réduire drastiquement l'épaisseur de la couche de silicium de typiquement 300-350 µm (cellules photovoltaïques classiques) à moins de 100 µm, jusqu'à 50 µm (voire en dessous), pour réduire le coût de ces dispositifs. Dans cette gamme, une partie importante du spectre du rayonnement incident, qui se propage au voisinage de la normale à la surface, ne serait pas absorbée dans l'épaisseur du matériau tandis que le coefficient de réflexion en face arrière, sauf précaution particulière, serait inférieur à typiquement 0,6 (incidence normale en face arrière).

L'une des applications de la présente invention concerne la texturation de couches de silicium polycristallin pour la fabrication de cellules solaires et est particulièrement intéressante pour les couches de faible épaisseur, inférieure à 300 µm. La texturation consiste à donner à la surface de la couche un relief prédéterminé, par exemple un réseau de rainures parallèles ou un réseau de pyramides.

Selon une première méthode de texturation connue, qui ne concerne que les plaques de silicium monocristallin et dont la surface est proche du plan cristallin (100), la texturation est effectuée par attaque chimique de la surface au moyen d'une solution KOH / isopropanol. Cette attaque, très anisotrope et spécifique de la face cristallographique (100), permet d'obtenir des pyramides de taille micrométrique très régulières et inclinées à 45° sur la surface macroscopique. Cette technique est cependant nettement moins efficace lorsqu'elle est appliquée à des plaques de silicium polycristallin, lesquelles sont de plus en plus utilisées pour des raisons de coût.

Dans ce cas, d'autres techniques ont été essayées. Toutes ces techniques sont des méthodes de gravure isotrope, c'est-à-dire supposées graver tous les grains dans des conditions similaires : attaque en milieu acide par voie chimique ou électrochimique (décrite dans l'article de V.Y.Yerokhov, R.Hezel, M.Lipinski, R.Ciach, H.Nagel, A.Mylyanych, P.Panek, Solar Energy Materials & Solar Cells 72 (2002) 291-298), attaque réactive en phase gazeuse (désigné par le terme "RIE" pour "Reactive Ion Etching") par exemple au moyen d'un plasma contenant des espèces chlorées (décrite dans l'article de S.Fujii, Y.Fukawa, H.Takahashi, Y.Inomata, K.Okada, K.Fukuii, K.Shirasawa, Solar Energy Materials & Solar Cells, 65 (2001) 269-275).

Une autre technique connue concerne la gravure mécanique, décrite dans l'article de F.Duerinckx, J.Szulfcik, J.Nijs, R.Mertens, C.Gerhards, C.Markmann, P.Fath, G.Willeke, High efficiency, mechanically V.Textured, screen printed multicrystalline silicon solar cells with silicon nitride passivation, Proceedings 2ème World Conférence on PV Solar Energy Conversion, 1998. La gravure mécanique consiste à former mécaniquement un relief, par exemple un réseau de rainures parallèles entre elles ou de pyramides, directement sur la surface de la couche de silicium à l'aide d'outils mécaniques tels qu'une meule à diamants. Cependant cette opération perturbe considérablement la structure du silicium sur une épaisseur d'environ dix microns, ce qui a pour effet d'induire des défauts dans tout le volume du silicium consécutivement aux traitements thermiques auxquels est soumis le silicium par la suite. La gravure mécanique est de surcroît lente et onéreuse, et donc industriellement inefficace.

Une autre technique connue concerne un procédé de dépot d'une mince pellicule de silicium sur une surface d'un ruban de carbone, voir EP-A2-0079567.

Chacune de ces techniques a des limitations sévères, soit en terme de coût (attaque électrochimique, attaque plasma et gravure mécanique), soit en terme d'efficacité (attaque chimique acide). Plusieurs d'entre elles ne sont pas applicables aux plaques très minces, d'épaisseur inférieure à 300 µm, généralement très fragiles, en raison des manipulations et / ou des contraintes mécaniques qu'elles induisent. C'est le cas de la gravure mécanique et dans une certaine mesure du décapage électrochimique (manipulations). Le procédé de la présente invention ne présente pas les inconvénients ci-dessus.

Une autre application de la présente invention concerne le marquage des plaques afin de différencier une plaque ou une série de plaques de silicium par rapport à d'autres plaques de silicium.

Une autre application de la présente invention concerne le renforcement de la rigidité des plaques de silicium minces.

De façon générale, la présente invention résout le problème de l'impression de plaques de silicium polycristallin, notamment de faibles épaisseurs, inférieures à 300 µm, en proposant un procédé moins coûteux que les méthodes de l'art antérieur, efficace car il ne perturbe pas la structure interne du silicium et qui peut être mis en oeuvre industriellement.

De façon plus précise, l'invention a pour objet un procédé selon l'objet de la revendication 1.

Le relief prédéterminé peut avoir une ou plusieurs fonctions. Il peut s'agir par exemple de texturer la ou les faces de la plaque de silicium. Dans ce cas le relief occupe au moins la majeure partie de la ou des faces. Il peut s'agir également, en plus ou indépendamment de la texturation, de marquer la couche de silicium par une référence pour différencier la plaque, ou une série de plaques, issue(s) de cette couche de silicium, par rapport à d'autres plaques de silicium. Le relief peut aussi avoir pour fonction, lorsqu'il ne concerne qu'une partie de la plaque, d'augmenter la rigidité des plaques de silicium minces, qui sont relativement souples, en créant des nervures.

L'invention s'appliquant tout particulièrement à la fabrication de cellules solaires, ledit relief peut être choisi de façon à texturer la majeure partie de la surface de la couche de silicium afin d'augmenter la probabilité d'absorption de la lumière incidente dans ladite couche.

Selon une première variante de réalisation de l'invention, ledit relief de texturation a la forme d'un réseau de pyramides sensiblement identiques, les faces latérales de chacune desdites pyramides formant de préférence avec la base de la pyramide des angles sensiblement égaux à 45 degrés. La hauteur desdites pyramides est avantageusement comprise entre 1 et 10 µm.

Selon l'invention ledit support est un ruban de carbone, lequel est recouvert d'un revêtement protecteur en graphite pyrolytique après impression de sa surface pour lui donner ladite forme complémentaire du relief.

Ladite face du support peut être imprimée pour lui donner u ne forme complémentaire dudit relief par impression d'une matrice sur ledit support, la surface d'impression de la matrice ayant la forme d'une surface plane sur laquelle a été imprimé ledit relief prédéterminé.

Selon une autre variante de réalisation de l'invention, ladite face du support est imprimée pour lui donner une forme complémentaire dudit relief par pincement et défilement dudit support entre deux rouleaux, la surface d'impression de l'un au moins desdits rouleaux ayant la forme dudit relief prédéterminé.

Ladite surface d'impression de ladite matrice ou dudit rouleau est de préférence réalisée en un matériau choisi parmi le carbone, le carbure de silicium, le silicium et le nitrure de silicium.

De façon avantageuse, les surfaces d'impression des deux rouleaux ont la forme dudit relief, les deux faces dudit support prenant alors la forme complémentaire dudit relief lors desdits pincement et défilement entre lesdits rouleaux.

Selon une autre variante de réalisation, une couche de silicium polycristallin est déposée simultanément et en régime continu sur les deux faces dudit ruban en le faisant traverser un bain de silicium fondu et en le tirant verticalement et à vitesse constante, de bas en haut, pour le sortir dudit bain, obtenant ainsi deux couches de silicium polycristallin, chacu ne ayant une surface ayant ledit relief.

Ledit support est préférentiellement éliminé par brûlage en chauffant à haute température l'ensemble formé par le support et le silicium polycristallin et la face du silicium polycristallin ayant la forme dudit relief est ensuite décapée.

Avantageusement, ledit support a une épaisseur comprise entre 200 et 350 µm, de préférence entre 200 et 300 µm, la couche de silicium polycristallin a une épaisseur comprise entre 40 et 300 µm et l'épaisseur dudit revêtement protecteur est sensiblement égale à 1 µm.

Selon une autre variante de réalisation, ledit relief est composé, indépendamment ou en plus de la texturation, d'un motif caractérisant ladite plaque ou une série de plaques de silicium. Ce motif peut être par exemple un code barre ou un numéro de référence.

Selon une autre variante de réalisation, indépendamment ou en plus de la texturation et/ou du motif caractérisant la plaque, des échancrures sont imprimées sur ladite face dudit support de sorte que des nervures, de forme complémentaire des échancrures, soient formées sur ladite surface de la couche de silicium, ce qui a pour effet d'augmenter la rigidité de la couche de silicium. La profondeur desdites échancrures peut être de quelques dizaines de micromètres et la plus grande largeur desdites nervures peut être au maximum de quelques millimètres.

Selon une autre variante de réalisation, chacun desdits rouleaux est formé d'au moins deux molettes dont chaque face forme une face d'impression, les molettes étant séparées par un disque ayant une partie en saillie au-dessus de la face d'impression des molettes, la surface d'impression des rouleaux étant constituée par les faces d'impression des molettes formant la texturation et/ou le motif de la couche de silicium et la partie en saillie du disque formant le relief en forme de nervure perpendiculaire à l'axe de rotation dudit rouleau. De façon avantageuse, chacun des rouleaux est composé d'une succession de molettes séparées par des disques, chacun des disques ayant une partie en saillie au-dessus de la surface des molettes, l'espacement entre lesdits disques constituant le motif caractérisant ladite plaque ou ladite série de plaques de silicium polycristallin.

Selon une autre variante de réalisation, lesdits rouleaux ou lesdites molettes comportent des rainures longitudinales, parallèles aux axes de rotation des rouleaux ou des molettes. Ces rainures longitudinales peuvent coexister avec les rainures formées par lesdits disques.

D'autres avantages et caractéristiques de l'invention apparaîtront au cours de la description qui va suivre de plusieurs modes de réalisation, donnés à titre d'exemples non limitatifs, en référence aux dessins annexés et sur lesquels:
- la figure 1 illustre le trajet d'un faisceau lumineux incident dans une couche de silicium dont la surface frontale a été texturée pour lui donner un relief en forme de pyramides,
- la figure 2 illustre de façon schématique le procédé de texturation des deux faces du support de la couche de silicium,
- la figure 3 représente le support et les couches de silicium obtenus à différentes étapes du procédé de fabrication des couches de silicium texturées,
- la figure 4 représente schématiquement le mode de réalisation préféré du procédé de fabrication des couches texturées,
- la figure 5 montre schématiquement les rouleaux formés de molettes et de disques permettant de texturer et/ou de marquer et de nervurer la surface de la couche de silicium, par l'intermédiaire de l'étape d'impression du support, et
- la figure 6 représente schématiquement en section une molette munie de rainures longitudinales, parallèlement à son axe de rotation.

Selon le procédé de l'invention, la fabrication d'une ou plusieurs plaques minces de silicium polycristallin consiste principalement à déposer ce silicium sous forme d'une couche mince sur la ou les deux faces d'un support qui a ou ont été préalablement imprimées. Le silicium étant déposé sur la surface en relief du support, le silicium épouse la forme de ce relief. En d'autres termes, la forme de la face de la couche de silicium en contact avec le support est obtenue par moulage du silicium liquide sur le support. Le relief de la face du support est donc choisi complémentaire de la forme que l'on veut donner au relief de la face de la couche mince.

Les figures 2, 3 et 4 illustrent le mode de réalisation préféré de l'invention selon lequel deux couches de silicium texturées, marquées et/ou nervurées sont fabriquées simultanément en déposant le silicium sur les deux faces d'un support constitué par un ruban. La première étape du procédé consiste à donner aux deux faces du ruban une forme complémentaire de la forme prédéterminée que l'on veut obtenir pour les faces des deux couches de silicium, faces en regard du support. C'est ce qu'illustre la figure 2, sur laquelle un ruban 28 (représenté en section) est pincé entre deux rouleaux 30 et 32. Ces rouleaux, de forme cylindrique, tournent autour de leurs axes de rotation 34 et 36 dans le sens des flèches respectivement 38 et 40, ce qui a pour effet de tirer le ruban 28 vers le haut, dans le sens de la flèche 42. Selon une autre forme de réalisation, les rouleaux 30 et 40 peuvent tourner libre ment autour de leurs axes de rotation 34 et 36, l'entraînement du ruban 28 se faisant par un autre moyen indépendant des rouleaux.

La surface d'impression de ces rouleaux, de préférence réalisée en carbone, carbure de silicium, silicium ou nitrure de silicium, a la forme du relief prédéterminé 44 que l'on veut donner à la surface de la couche de silicium. Le ruban 28 est de préférence en carbone (graphite expansé laminé), un matériau souple, peu élastique et de faible densité (comprise entre 0,6 et 1,3). Ce carbone est par exemple commercialisé sous les appelations "Papyex" de la société Le Carbone Lorraine, "Sigraflex" de la société SGL Carbon et "Grafoil' de la société Union Carbide. Le caractère peu élastique de ces matériaux permet de réaliser sur chacune des surfaces 46 et 48 du ruban 28 un excellent moulage du relief 44 des rouleaux lors du défilement du ruban 28 entre les rouleaux 30 et 32. Le ruban 28 a une épaisseur approximative de 200 à 300 µm et peut être livré en rouleaux d'un mètre de largeur et de plusieurs centaines de mètres de longueur. Cependant, pour le mode de réalisation décrit ici, on utilise de préférence une largeur d'environ quinze centimètres.

Sur la figure 2, qui n'est qu'une représentation schématique, le relief 44 peut être un réseau de rainures parallèles ou perpendiculaires aux axes de rotation 34 et 36 des rouleaux, lorsque le but recherché est la texturation des faces des couches de silicium. Dans le premier cas, les rainures sont horizontales et orientées dans le sens de la largeur du ruban. Dans le deuxième cas, les rainures sont verticales et orientées dans le sens de la longueur du ruban. Dans les deux cas on obtient un réseau anisotrope à une dimension. On notera que ces deux motifs appliqués à la texturation du ruban de silicium donnent le même résultat, du point de vue de la texturation de la plaque de silicium, qu'une texturation directe du silicium par voie mécanique avec un diamant mais sans les inconvénients de cette dernière technique (lente, agressive et nécessité d'une finition par une attaque chimique en profondeur pour éliminer les dommages de la gravure diamant). Le relief 44 peut également, et de préférence, être un réseau de pyramides adjacentes tel qu'illustré sur la figure 1. Dans tous les cas où l'application considérée est la texturation de la surface, la forme du relief est choisie de façon à augmenter la probabilité d'absorption de la lumière incidente dans la couche de silicium.

La figure 3 illustre les étapes suivantes de la fabrication des couches de silicium. En 3A, on a représenté un ruban de carbone 50 avec ses deux faces texturées 52 et 54 obtenues selon la méthode illustrée sur la figure 2. Ces deux faces 52 et 54 sont ensuite recouvertes (3B) d'une fine couche protectrice 56 et 58 de graphite pyrolytique, ou pyrocarbone, d'épaisseur micrométrique. Du fait de la très faible épaisseur de cette couche, le relief des faces 52 et 54 est conservé. Ce revêtement protecteur est nécessaire car le carbone du ruban 50 réagit avec le silicium fondu pour donner naissance à du carbure de silicium, alors que le graphite pyrolytique est inerte vis-à-vis du silicium fondu.

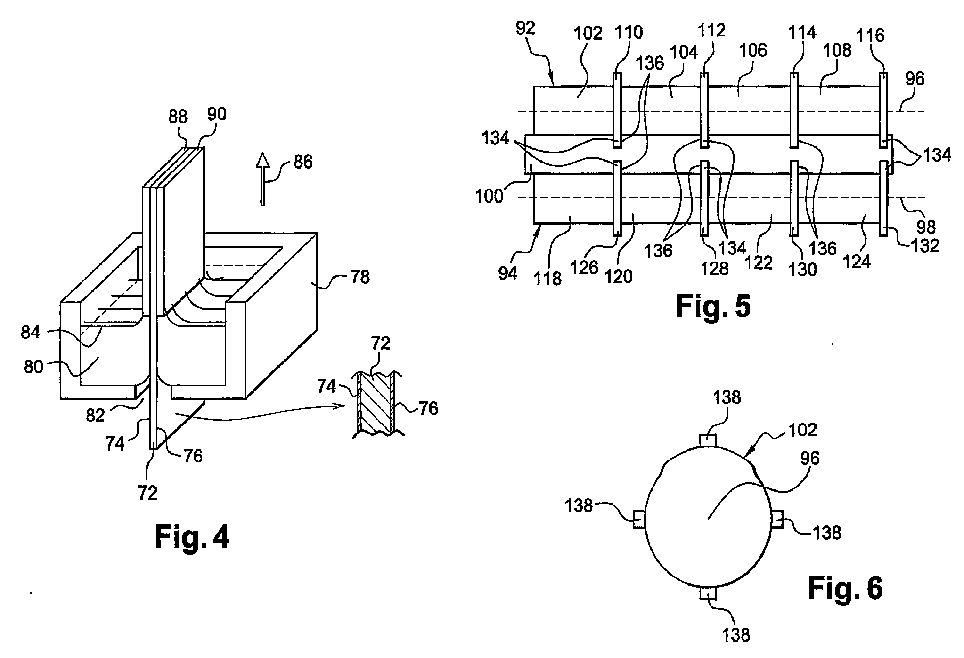

En 3C, on a montré le ruban de carbone obtenu en 3B avec ses faces en relief 56 et 58 sur lesquelles ont été déposées les deux couches 60 et 62 de silicium polycristallin. La méthode préférée pour le dépôt de ces couches est illustrée sur la figure 4. Le ruban sert à la fois de support des couches de silicium et de moyens permettant de texturer, de marquer et/ou de nervurer les faces 64 et 66 des couches de silicium en regard du ruban selon le relief prédéterminé 44 des rouleaux 30 et 32 (figure 2). En effet, les faces 64 et 66 des couches de silicium épousent, comme par moulage, le relief des faces imprimées respectivement 56 et 58. Ce relief est de forme complémentaire de celui des faces 56 et 58 du ruban support 50; il est donc de forme identique au relief 44 des rouleaux 30 et 32 de la figure 2. On obtient ainsi pour les couches de silicium le relief prédéterminé recherché.

L'étape suivante consiste tout d'abo rd à couper en plaques, généralement rectangulaires, le ruban composite formé du ruban 50 et des couches de silicium 60 et 62. Puis le ruban support 50 est éliminé (étape 3D) par brûlage sous air à haute température (environ 1000 degrés C) afin d'obtenir deux plaques 68 et 70 de silicium polycristallin. Les faces texturées des plaques subissent ensuite un léger décapage pour éliminer la couche oxydée, de la silice, qui s'est formée en surface. Cette couche oxydée est de très faible épaisseur, de l'ordre de quelques dixièmes de micromètres. Le décapage peut se faire par différentes voies classiques à l'aide par exemple d'acide fluorhydrique gazeux, d'une solution aqueuse d'acide fluorhydrique diluée à 5% dans l'eau, à laquelle peut éventuellement être ajoutée 10% d'acide nitrique, ou encore par attaque réactive en phase gazeuse (appelée "RIE" pour "Reactive Ion Etching") au moyen par exemple d'un plasma contenant des espèces chlorées.

Le dépôt des couches de silicium 60 et 62 sur le ruban support 50 est avantageusement effectué selon le procédé illustré sur la figure 4. Ce procédé, appelé procédé "RST" (pour Ruban de silicium sur Substrat de carbone Temporaire), est décrit dans plusieurs brevets, par exemple FR 2 386 359, FR 2 550 965, FR 2 568 490 ou EP 0079567. Cependant le procédé décrit dans ces brevets n'utilise pas un ruban de carbone imprimé comme le ruban 50. Les couches de silicium fabriquées selon les enseignements de ces brevets ne sont donc pas imprimées (par exemple texturées, marquées et/ou nervurées). Sur la figure 4, les faces 74 et 76 d'un ruban de carbone souple 72 (identique au ruban 50 de la figure 3) ont été imprimées (figure 3A) pour prendre la forme complémentaire du relief prédéterminé grâce au procédé illustré sur la figure 2 et ensuite recouvertes d'une couche protectrice de graphite pyrolytique (figure 3B). Un creuset 78 en silice ou en carbone contient un bain 80 de silicium fondu et des moyens (non représentés) pour chauffer le silicium, par exemple des résistances chauffantes entourant le creuset. Le fond du creuset 78 comporte une fente rectiligne 82 à travers laquelle passe verticalement le ruban de carbone 72. Ce dernier est mis en mouvement, verticalement et de bas en haut, par des moyens non représentés et sort du bain 80 en traversant sa surface d'équilibre horizontale 84. La largeur et la longueur de la fente 82 sont déterminées pour que le ménisque de raccordement de silicium liquide soit stable dans cette fente.

Lorsque le ruban 72 se déplace dans le sens de la flèche 86, une couche de silicium polycristallin 88 et 90 se dépose sur les faces imprimées respectivement 74 et 76 du ruban support 72. On obtient ainsi l'équivalent du ruban de carbone 50 et des couches 60 et 62 de la figure 3C. L'ensemble ruban support et couches de silicium est ensuite découpé pour former des plaques. Le ruban support 72 est ensuite éli miné et les deux couches de silicium polycristallin obtenues sont traitées comme indiqué précédemment en regard de la figure 3D.

Le procédé décrit en regard de la figure 2 est mis en oeuvre à l'aide de deux rouleaux 30 et 32 dont les surfaces d'impression comporte un relief en forme de pyramides, permettant de texturer la couche de silicium. La figure 5 montre schématiquement une forme de réalisation des rouleaux permettant de texturer et/ou de marquer et de nervurer la couche de silicium. Deux rouleaux 92 et 94, qui se font face, tournent autour de leurs axes de rotation parallèles 96 et 98. Un ruban de carbone 100 (montré en section perpendiculairement à sa longueur), destiné à servir de support à la couche de silicium polycristallin, est pincé entre les rouleaux 92 et 94 et défile entre les rouleaux dans le sens perpendiculaire à la feuille de dessin. Le rouleau 92 se compose d'une série de molettes 102, 104, 106 et 108 séparées par des disques 110, 112, 114 et 116. Ces molettes et ces disques ont pour axe de rotation l'axe de rotation 96. De la même façon, le roule au 94 se compose de molettes 118, 120, 122 et 124 séparées par des disques 126, 128, 130 et 132, les molettes et les disques ayant pour axe de rotation l'axe 98. La surface cylindrique (surface d'impression) de chacune des molettes peut avoir un relief ou un motif d'impression permettant de texturer et/ou de marquer par une référence le ruban de carbone 100. Le diamètre des disques est légèrement supérieur à celui des molettes de sorte qu'une partie 134 de chaque disque (la circonférence extérieure) fait saillie par rapport à la surface d'impression des molettes. Il en résulte que le relief imprimé dans le ruban 100 par les disques 110 à 116 et 126 à 132 sont des échancrures 136. En déposant la couche de silicium sur le ruban, à l'aide du procédé illustré sur la figure 4 par exemple, la surface de la couche de silicium comportera des rainures, de forme complémentaire aux échancrures 136, dans le sens longitudinal du ruban 100. Ces rainures renforcent la rigidité de la couche de silicium.

Des échancrures peuvent également être réalisées dans le sens de la largeur du ruban. Pour ce faire, les molettes compo rtent en relief des nervures disposées sur leurs surfaces d'impression. C'est ce que montre schématiquement la figure 6 sur laquelle la molette 102 est représentée en coupe, perpendiculairement à l'axe de rotation 96. Sur la surface cylindrique d'impression de cette molette sont disposées des nervures 138 parallèlement à l'axe de rotation 96. Ces nervures provoquent des échancrures de forme complémentaire dans le ruban support 100 et des nervures de même forme sur la couche de silicium. De telles nervures 138 peuvent être disposées de la même façon sur les surfaces d'impression de toutes les autres molettes ou d'une partie seulement selon le relief désiré pour la couche de silicium. Le nombre et l'espacement des nervures 138 peuvent être variables.

En combinant les disques de la figure 5 avec les rainures de la figure 6, on obtient un relief en forme de gaufre constitué par un quadrillage de nervures, les unes étant dans le sens de la longueur du ruban et les autres dans le sens de la largeur du ruban. Dans ce cas, il est préférable que les nervures ne soient pas en contact direct avec les disques, mais soient espacées par un interstice de l'ordre du millimètre ou inférieur.

De préférence, la plus grande largeur des nervures est au plus d'un millimètre et leur hauteur est de quelques dizaines de micromètres.

La section des nervures peut prendre toute forme appropriée au but poursuivi (renforcement de la rigidité de la couche de silicium par exemple), telle qu'une forme en "U" ou en "V".

Le procédé selon l'invention apporte une solution industrielle à l'impression de plaques de silicium polycristallin, comme la texturation, le marquage et/ou le renforcement de la rigidité, sans qu'aucune contrainte mécanique ou chimique ne soit appliquée à la plaque. La structure interne du silicium n'est donc pas endommagée. Lorsque le relief prédéterminé est un réseau de pyramides sensiblement identiques, la texturation obtenue est complètement isotrope avec des possibilités de modulation sur la période du réseau de pyramides et la forme des pyramides. Le procédé peut être mis en oeuvre à faible coût, le coût le plus important étant la fabrication des rouleaux 30 et 32 ou 92 et 94 lesquels peuvent être utilisés pour la fabrication de très nombreuses plaques. La texturation obtenue peut être importante (forte densité et/ou intensité du relief) ce qui permet de fabriquer des cellules photovoltaïques à très haut rendement de conversion de la lumière en paires électron-trou. De plus la consommation de produits chimiques est très réduite puisqu'ils ne sont utilisés que pour éliminer la couche de silice qui s'est formée au cours de l'élimination par chauffage du ruban support en carbone.

Selon le mode de réalisation préféré de l'invention décrit précédemment, les deux faces du ruban support en carbone sont texturées et deux couches texturées de silicium polycristallin sont fabriquées simultanément. On pourrait bien entendu ne texturer qu'une seule face du ruban support (en ne texturant qu'un seul des deux rouleaux 30 et 32) et n'obtenir qu'une seule couche de silicium texturée, sans sortir du cadre de la présente invention. De même, un procédé différent de celui illustré sur la figure 4 pourrait être utilisé pour déposer une couche de si licium sur un support. Au lieu d'utiliser des rouleaux pour imprimer le ruban support, on pourrait utiliser une matrice ayant une surface plane imprimée avec le relief prédéterminé.

## Revendications

1. Procédé de fabrication d'au moins une plaque de silicium polycristallin (68, 70) dont l'une (64, 66) des deux faces a un relief prédéterminé, selon lequel une couche de silicium polycristallin (60, 62) est déposée sur au moins l'une (56, 58) des deux faces d'un support (50), **ledit support étant un ruban de carbone**, **caractérisé en ce que**:
- ladite face (52, 54) du support (50) est imprimée pour lui donner une forme complémentaire dudit relief,
- **ledit support est recouvert d'un revêtement protecteur (56, 58) en graphite pyrolytique après impression de sa surface (52, 54) pour lui donner ladite forme complémentaire du relief**,
- ladite couche de silicium polycristallin (60, 62) est déposée sur ladite face imprimée (56, 58) du support (50), la surface (64 ou 66) de ladite couche de silicium polycristallin située en contact de ladite face imprimée (56 ou 58) épousant alors la forme dudit relief,
- ladite couche de silicium polycristallin (60 ou 62) est découpée, et
- ledit support **et ledit revêtement protecteur** sont éliminés afin d'obtenir ladite plaque de silicium polycristallin (68 ou 70).

2. Procédé selon la revendication 1, **caractérisée en ce que** ladite face (46, 48) du support est imprimée pour lui donner une forme complémentaire dudit relief (44) par pincement et défilement dudit support (28) entre deux rouleaux (30,32), la surface d'impression de l'un au moins desdits rouleaux ayant la forme dudit relief prédéterminé.

3. Procédé selon la revendication 1, **caractérisé en ce que** ladite face du support est imprimée pour lui donner une forme complémentaire dudit relief par impression d'une matrice sur ledit support, la surface d'impression de la matrice ayant la forme d'une surface plane sur laquelle a été imprimé ledit relief prédéterminé.

4. Procédé selon l'une des revendications 2 et 3, **caractérisé en ce que** ladite surface dudit rouleau (30,32) ou de ladite matrice est réalisée en un matériau choisi parmi le carbone, le carbure de silicium, le silicium et le nitrure de silicium.

5. Procédé selon l'une des revendications 2 et 4, **caractérisé en ce que** les surfaces d'impression des deux rouleaux (30,32) ont la forme dudit relief, les deux faces (46,48) dudit support (28) prenant alors la forme complémentaire dudit relief (44) lors desdits pincement et défilement entre lesdits rouleaux.

6. Procédé selon les revendications 1 et 5, **caractérisé en ce qu'**une couche de silicium polycristallin (88, 90) est déposée simultanément et en régime continu sur les deux faces (74, 76) dudit ruban (72) en le faisant traverser un bain de silicium fondu (80) et en le tirant verticalement et à vitesse constante, de bas en haut (86), pour le sortir dudit bain, obtenant ainsi deux couches (88, 90) de silicium polycristallin, chacune ayant une surface ayant ledit relief.

7. Procédé selon l'une des revendications précédente, **caractérisé en ce que** ledit support (28, 50, 72, 100) est éliminé par brûlage en chauffant à haute température l'ensemble formé par le support et le silicium polycristallin.

8. Procédé selon la revendication 7, **caractérisé en ce que** la face (64, 66) du silicium polycristallin ayant la forme dudit relief est décapée après brûlage dudit support.

9. Procédé selon l'une des revendications précédentes, **caractérisé en ce que** ledit support (28, 50, 72, 100) a une épaisseur comprise entre 200 et 350 µm, de préférence entre 200 et 300 µm.

10. Procédé selon l'une des revendications précédentes, **caractérisé en ce que** la couche de silicium polycristallin (68, 70, 88, 90) a une épaisseur comprise entre 40 et 300 µm.

11. Procédé selon la revendication 1, **caractérisé en ce que** l'épaisseur dudit revêtement protecteur (56, 58) est sensiblement égale à 1 µm.

12. Procédé selon l'une des revendications précédentes, **caractérisé en ce que** ladite face (46, 48, 52, 54) dudit support (28, 50) est imprimée de façon à texturer ladite face (64, 66) de ladite couche (68, 70) de silicium polycristallin, ledit relief (44) étant choisi de façon à augmenter la probabilité d'absorption de la lumière incidente dans ladite couche.

13. Procédé selon la revendication 12, **caractérisé en ce que** ledit relief a la forme d'un réseau de pyramides (14) sensiblement identiques.

14. Procédé selon la revendication 13, **caractérisé en ce que** les faces latérales de chacune desdites pyramides (14) forment avec la base de la pyramide des angles sensiblement égaux à 45 degrés.

15. Procédé selon l'une des revendications 13 et 14, **caractérisé en ce que** la hauteur desdites pyramides (14) est comprise entre 1 et 10 µm.

16. Procédé selon l'une des revendications précédentes **caractérisé en ce que** ladite face dudit support (28, 50, 72, 100) est imprimée de sorte que ladite surface de ladite couche de silicium soit marquée d'un motif caractérisant ladite plaque ou une série de plaques de silicium polycristallin.

17. Procédé selon la revendication 16, **caractérisé en ce que** ledit motif est un code barre.

18. Procédé selon la revendication 16, **caractérisé en ce que** ledit motif est un numéro.

19. Procédé selon l'une des revendications 12 à 15 et 16 à 18, **caractérisé en ce que** ledit relief est composé de la texturation de ladite face de ladite couche de silicium polycristallin et dudit motif caractérisant ladite plaque.

20. Procédé selon l'une des revendications précédentes **caractérisé en ce que** des échancrures sont imprimées sur ladite face dudit support (100) de sorte que des nervures, de forme complémentaire des échancrures, soient formées sur ladite surface de la couche de silicium, ce qui a pour effet d'augmenter la rigidité de ladite couche.

21. Procédé selon la revendication 20, **caractérisé en ce que** la profondeur desdites échancrures est de quelques dizaines de micromètres.

22. Procédé selon l'une des revendications 20 et 21, **caractérisé en ce que** la plus grande largeur desdites nervures est au plus de quelques millimètres.

23. Procédé selon la revendication 1 et l'une des revendications 20 à 22, **caractérisé en ce que** lesdites nervures sont dans le sens de la longueur dudit ruban (100).

24. Procédé selon la revendication 1 et l'une des revendications 20 à 22, **caractérisé en ce que** lesdites nervures sont dans le sens de la largeur dudit ruban (100).

25. Procédé selon les revendications 23 et 24, **caractérisé en ce que** ledit relief est en forme de gaufre, constitué par un quadrillage de nervures dans le sens de la longueur et de la largeur dudit ruban.

26. Procédé selon les revendications 5 et 23, **caractérisé en ce que** chacun desdits rouleaux (92,94) est formé d'au moins deux molettes (102-108 et 118-124) dont chaque face forme une face d'impression, lesdites molettes étant séparées par un disque (110-116 et 126-132) ayant une partie en saillie (134) au-dessus de la face d'impression desdites molettes, ladite surface d'impression des rouleaux étant constituée par lesdites faces d'impression desdites molettes formant la texturation et/ou le marquage de ladite couche de silicium et ladite partie en saillie (134) dudit disque formant des échancrures 136 dans le ruban support (100) et formant ledit relief en forme de nervures dans la couche de silicium.

27. Procédé selon les revendications 16 et 26, **caractérisé en ce que** chacun desdits rouleaux (92, 94) est composé d'une succession de molettes (102-108 et 118-124) séparées par des disques (110-116 et 126-132), chacun desdits disques ayant une partie en saillie (134) au-dessus de la surface desdites molettes créant des échancrures (136) dans le ruban support (100), l'espacement entre lesdites échancrures (136) constituant ledit motif caractérisant ladite plaque ou ladite série de plaques de silicium polycristallin.

28. Procédé selon les revendications 5 et 24, **caractérisé en ce que** chacun desdits rouleaux (92, 94) est formé d'au moins deux molettes tournant autour d'un axe de rotation et dont chaque face forme une face d'impression, au moins l'une lesdites molettes comportant des rainures longitudinales (134) parallèles audit axe de rotation.

## Claims

1. A method for making at least one polycrystalline silicon wafer (68, 70), whereof one (64, 66) of the two faces has a predetermined relief, according to which a polycrystalline silicon layer (60, 62) is deposited on at least one (56, 58) of the two faces of a support (50), said support being a carbon strip, **characterized in that**:
- said face (52, 54) of the support (50) is printed so as to give it a shape mating said relief,
- said support is covered with a protective coating (56, 58) in pyrolytic graphite after printing its surface (52, 54) in order to give it said shape mating the relief,
- said polycrystalline silicon layer (60, 62) is deposited on said printed face (56, 58) of the support (50), the surface (64 or 66) of said polycrystalline silicon layer located in contact with said printed face (56 or 58) then fitting the shape of said relief,
- said polycrystalline silicon layer (60 or 62) is cut out, and
- said support and said protective coating are removed in order to obtain said polycrystalline silicon wafer (68 or 70).

2. The method according to claim 1, **characterized in that** said face (46, 48) of the support is printed so as to give it a shape (44) mating said relief by nipping and having said support (28) pass between two rollers (30, 32), the printing surface of at least one of said rollers having the shape of said predetermined relief.

3. The method according to claim 1, **characterized in that** said face of the support is printed in order to give it a shape mating said relief by printing a matrix on said support, the printing surface of the matrix having the shape of a planar surface on which said predetermined relief was printed.

4. The method according to one of claims 2 and 3, **characterized in that** said surface of said roller (30, 32) of said matrix is made in a material selected from carbon, silicon carbide, silicon and silicon nitride.

5. The method according to one of claims 2 and 4, **characterized in that** the printing surfaces of both rollers (30, 32) have the shape of said relief, both faces (46, 48) of said support (28) then assuming the shape mating said relief (44) during said nipping and passing between said rollers.

6. The method according to claims 1 and 5, **characterized in that** a polycrystalline silicon layer (88, 90) is simultaneously and continuously deposited on both faces (74, 76) of said strip (72) by having it cross a molten silicon bath (80) and by drawing it vertically and at constant speed, from bottom to top (86), in order to extract it from said bath, thereby obtaining two layers (88, 90) of polycrystalline silicon, each having a surface with said relief.

7. The method according to one of the preceding claims, **characterized in that** said support (28, 50, 72, 100) is removed by burning upon heating to a high temperature the assembly formed by the support and the polycrystalline silicon.

8. The method according to claim 7, **characterized in that** the face (64, 66) of the polycrystalline silicon having the shape of said relief is cleaned after burning said support.

9. The method according to one of the preceding claims, **characterized in that** said support (28, 50, 72, 100) has a thickness comprised between 200 and 350 µm, preferably between 200 and 300 µm.

10. The method according to one of the preceding claims, **characterized in that** the polycrystalline silicon layer (68, 70, 88, 90) has a thickness comprised between 40 and 300 µm.

11. The method according to claim 1, **characterized in that** the thickness of said protective coating (56, 58) is substantially equal to 1 µm.

12. The method according to one of the preceding claims, **characterized in that** said face (46, 48, 52, 54) of said support (28, 50) is printed so as to texture said face (64, 66) of said polycrystalline silicon layer (68, 70), said relief (44) being selected so as to increase the probability of absorption of incident light in said layer.

13. The method according to claim 12, **characterized in that** said relief has the shape of a lattice of substantially identical pyramids (14).

14. The method according to claim 13, **characterized in that** the lateral faces of each of said pyramids (14) form with the base of the pyramid, angles substantially equal to 45 degrees.

15. The method according to one of claims 13 and 14, **characterized in that** the height of said pyramids (14) is comprised between 1 and 10 µm.

16. The method according to one of the preceding claims, **characterized in that** said face of said support (28, 50, 72, 100) is printed so that said surface of said silicon layer is marked with a pattern, characterizing said wafer or series of wafers of polycrystalline silicon.

17. The method according to claim 16, **characterized in that** said pattern is a barcode.

18. The method according to claim 16, **characterized in that** said pattern is a number.

19. The method according to one of claims 12 to 15 and 16 to 18, **characterized in that** said relief consists of the texturation of said face of said polycrystalline silicon layer, and of said pattern characterizing said wafer.

20. The method according to one of the preceding claims, **characterized in that** notches are printed on said face of said support (100), so that ribs with a shape mating the notches are formed on said surface of the silicon layer, which has the effect of increasing the rigidity of said layer.

21. The method according to claim 20, **characterized in that** the depth of said notches is a few tens of micrometers.

22. The method according to one of claims 20 and 21, **characterized in that** the largest width of said ribs is at most a few millimeters.

23. The method according to claim 1 and to one of claims 20 to 22, **characterized in that** said ribs are in the direction of the length of said strip (100).

24. The method according to claim 1 and to one of claims 20 to 22, **characterized in that** said ribs are in the direction of the width of said strip (100).

25. The method according to claims 23 and 24, **characterized in that** said relief is honeycomb-shaped, formed by a grid of ribs in the direction of the length and of the width of said strip.

26. The method according to claims 5 and 23, **characterized in that** each of said rollers (92, 94) is formed with at least two knurls (102-108 and 118-124), each face of which forms a printing face, said knurls being separated by a disc (110-116 and 126-132) having a protruding portion (134) above the printing face of said knurls, said printing surface of the rollers being formed by said printing faces of said knurls forming the texturation and/or marking of said silicon layer, and said protruding portion (134) of said disc forming notches (136) in the supporting strip (100) and forming said relief in the form of ribs in the silicon layer.

27. The method according to claims 16 and 26, **characterized in that** each of said rollers (92, 94) consists of a succession of knurls (102-108 and 118-124) separated by discs (110-116 and 126-132), each of said discs having a protruding portion (134) above the surface of said knurls creating notches (136) in the supporting strip (100), the spacing between said notches (136) forming said pattern, characterizing said wafer or said series of wafers of polycrystalline silicon.

28. The method according to claims 5 and 24, **characterized in that** each of said rollers (92, 94) is formed with at least two knurls rotating around an axis of rotation and each face of which forms a printing face, at least one of said knurls including longitudinal grooves (134) parallel to said axis of rotation.

## Patentansprüche

1. Verfahren zur Herstellung mindestens einer polykristallinen Siliziumplatte (68, 70), von der eine (64, 66) der zwei Seiten ein vorbestimmtes Relief hat, wobei eine polykristalline Siliziumschicht (60, 62) auf mindestens einer (56, 58) der zwei Seiten eines Trägers (50) aufgebracht ist, wobei der Träger ein Karbonband ist, **dadurch gekennzeichnet, dass**:
- die Seite (52, 54) des Trägers (50) bedruckt ist, um ihr eine komplementäre Form des Reliefs zu verleihen,
- der Träger nach dem Bedrucken seiner Oberfläche (52, 54) mit einer Schutzschicht (56, 58) aus pyrolytischem Graphit bedeckt ist, um ihm die komplementäre Form des Reliefs zu verleihen,
- die polykristalline Siliziumschicht (60, 62) auf die bedruckte Seite (56, 58) des Trägers (50) aufgebracht wird, wobei die Oberfläche (64 oder 66) der polykristallinen Siliziumschicht im Kontakt mit der bedruckten Seite (56 oder 58) dann die Form des Reliefs annimmt,
- die polykristalline Siliziumschicht (60 oder 62) geschnitten wird und
- der Träger und die Schutzschicht entfernt werden, um die polykristalline Siliziumplatte (68 oder 70) zu erhalten.

2. Verfahren nach Anspruch 1, **dadurch gekennzeichnet, dass** die Seite (46, 48) des Trägers bedruckt wird, um ihr durch Klemmen und Durchlaufen des Trägers (28) zwischen zwei Walzen (30, 32) eine komplementäre Form des Reliefs (44) zu verleihen, wobei die Druckoberfläche mindestens einer der Walzen die Form des vorbestimmten Reliefs hat.

3. Verfahren nach Anspruch 1, **dadurch gekennzeichnet, dass** die Seite des Trägers bedruckt wird, um ihr durch Drucken einer Matrix auf dem Träger eine komplementäre Form des Reliefs zu verleihen, wobei die Druckoberfläche der Matrix die Form einer ebenen Oberfläche hat, auf der das vorbestimmte Relief gedruckt worden ist.

4. Verfahren nach einem der Ansprüche 2 und 3, **dadurch gekennzeichnet, dass** die Oberfläche der Walze (30, 32) oder der Matrix aus einem Material hergestellt ist, das aus dem Karbon, dem Siliziumkarbid, dem Silizium und dem Siliziumnitrid ausgewählt ist.

5. Verfahren nach einem der Ansprüche 2 und 4, **dadurch gekennzeichnet, dass** die Druckoberflächen der zwei Walzen (30, 32) die Form des Reliefs haben, wobei die zwei Seiten (46, 48) des Trägers (28) dann beim Klemmen und Durchlaufen zwischen den Walzen die komplementäre Form des Reliefs (44) annehmen.

6. Verfahren nach den Ansprüchen 1 und 5, **dadurch gekennzeichnet, dass** eine polykristalline Siliziumschicht (88, 90) gleichzeitig und kontinuierlich auf den zwei Seiten (74, 76) des Bandes (72) aufgebracht wird, indem es durch ein Bad geschmolzenen Siliziums (80) geführt wird und indem es vertikal und mit konstanter Geschwindigkeit von unten nach oben (86) gezogen wird, um es aus dem Bad zu befördern, wobei es somit zwei Schichten (88, 90) polykristallinen Siliziums erhält, wobei jede eine Oberfläche hat, die das Relief hat.

7. Verfahren nach einem der vorangehenden Ansprüche, **dadurch gekennzeichnet**, das der Träger (28, 50, 72, 100) durch Brennen entfernt wird, indem die von dem Träger und dem polykristallinem Silizium gebildete Gruppe auf hohe Temperatur erwärmt wird.

8. Verfahren nach Anspruch 7, **dadurch gekennzeichnet, dass** die Seite (64, 66) des polykristallinen Siliziums, das die Form des Reliefs hat, nach Verbrennen des Trägers abgebeizt wird.

9. Verfahren nach einem der vorangehenden Ansprüche, **dadurch gekennzeichnet, dass** der Träger (28, 50, 72, 100) eine Dicke zwischen 200 und 350 µm, vorzugsweise zwischen 200 und 300 µm, inklusive hat.

10. Verfahren nach einem der vorangehenden Ansprüche, **dadurch gekennzeichnet, dass** die polykristalline Siliziumschicht (68, 70, 88, 90) eine Dicke zwischen 40 und 300 µm inklusive hat.

11. Verfahren nach Anspruch 1, **dadurch gekennzeichnet, dass** die Dicke des Schutzüberzugs (56, 58) etwa gleich 1 µm ist.

12. Verfahren nach einem der vorangehenden Ansprüche, **dadurch gekennzeichnet, dass** die Seite (46, 48, 52, 54) des Trägers (28, 50) derart bedruckt ist, dass die Seite (64, 66) der polykristallinen Siliziumschicht (68, 70) texturiert wird, wobei das Relief (44) derart ausgewählt ist, dass die Absorptionswahrscheinlichkeit des in die Schicht einfallenden Lichts erhöht wird.

13. Verfahren nach Anspruch 12, **dadurch gekennzeichnet, dass** das Relief die Form eines Netzwerks etwa identischer Pyramiden (14) hat.

14. Verfahren nach Anspruch 13, **dadurch gekennzeichnet, dass** die Seitenflächen jeder der Pyramiden (14) mit der Basis der Pyramide Winkel von etwa gleich 45 Grad bilden.

15. Verfahren nach einem der Ansprüche 13 und 14, **dadurch gekennzeichnet, dass** die Höhe der Pyramiden (14) zwischen 1 und 10 µm inklusive ist.

16. Verfahren nach einem der vorangehenden Ansprüche, **dadurch gekennzeichnet, dass** die Fläche des Trägers (28, 50, 72, 100) derart bedruckt ist, dass die Oberfläche der Siliziumschicht mit einem Motiv markiert ist, das die polykristalline Siliziumplatte oder eine Plattenreihe kennzeichnet.

17. Verfahren nach Anspruch 16, **dadurch gekennzeichnet, dass** das Motiv ein Strichcode ist.

18. Verfahren nach Anspruch 16, **dadurch gekennzeichnet, dass** das Motiv eine Nummer ist.

19. Verfahren nach einem der Ansprüche 12 bis 15 und 16 bis 18, **dadurch gekennzeichnet, dass** das Relief aus der Texturierung der Seite der polykristallinen Siliziumschicht und dem die Platte kennzeichnenden Motiv zusammengesetzt ist.

20. Verfahren nach einem der vorangehenden Ansprüche, **dadurch gekennzeichnet, dass** auf der Seite des Trägers (100) Einbuchtungen derart gedruckt sind, dass zu den Einbuchtungen komplementär geformte Rippen auf der Oberfläche der Siliziumschicht geformt sind, was die Erhöhung der Festigkeit der Schicht bewirkt.

21. Verfahren nach Anspruch 20, **dadurch gekennzeichnet, dass** die Tiefe der Einbuchtungen einige Dutzend Mikrometer beträgt.

22. Verfahren nach einem der Ansprüche 20 und 21, **dadurch gekennzeichnet, dass** die größte Breite der Rippen höchsten einige Millimeter beträgt.

23. Verfahren nach Anspruch 1 und einem der Ansprüche 20 bis 22, **dadurch gekennzeichnet, dass** die Rippen in Richtung der Länge des Bandes (100) verlaufen.

24. Verfahren nach Anspruch 1 und einem der Ansprüche 20 bis 22, **dadurch gekennzeichnet, dass** die Rippen in Richtung der Breite des Bandes (100) verlaufen.

25. Verfahren nach den Ansprüchen 23 und 24, **dadurch gekennzeichnet, dass** das Relief in Waffelform ist, das von einem Rippen-Rasternetz in Richtung der Länge und der Breite des Bandes gebildet wird.

26. Verfahren nach den Ansprüchen 5 und 23, **dadurch gekennzeichnet, dass** die jede der Walzen (92, 94) von mindestens zwei Prägewalzen (102-108 und 118-124) gebildet wird, von denen jede Seite eine Druckseite bildet, wobei die Prägewalzen durch eine Scheibe (110-116 und 126-132) getrennt sind, die einen über die Druckseite der Prägewalzen hervorstehenden Abschnitt (134) hat, wobei die Druckoberfläche der Walzen von den Druckseiten der Prägewalzen gebildet wird, die die Texturierung und/oder die Markierung der Siliziumschicht bilden und der hervorstehende Abschnitt (134) der Scheibe Einbuchtungen (136) in das Trägerband (100) formt und das Relief in Form von Rippen in die Siliziumschicht formt.

27. Verfahren nach einem der Ansprüche 16 und 26, **dadurch gekennzeichnet, dass** sich jede der Walzen (92, 94) aus einer Abfolge von durch Scheiben (110-116 und 126-132) getrennten Prägewalzen (102-108 und 118-124) zusammensetzt, wobei jede der Scheiben einen über die Oberfläche der Prägewalzen hervorstehenden Abschnitt (134) hat, der im Trägerband (100) Einbuchtungen (136) schafft, wobei der Abstand zwischen den Einbuchtungen (136) das Relief darstellt, das die polykristalline Siliziumplatte oder die Plattenreihe kennzeichnet.

28. Verfahren nach einem der Ansprüche 5 und 24, **dadurch gekennzeichnet, dass** jede der Walzen (92, 94) von mindestens zwei Prägewalzen gebildet wird, die um eine Drehachse drehen und von denen jede Seite eine Druckseite bildet, wobei mindestens eine der Prägewalzen längliche Rillen (134) parallel zur Drehachse aufweist.
